# EUROPÄISCHE PATENTSCHRIFT

(11) **EP 3 989 687 B1**
(45) Veröffentlichungstag und Bekanntmachung des Hinweises auf die Patenterteilung: **11.09.2024**
(21) Anmeldenummer: 21196225.3
(22) Anmeldetag: 13.09.2021
(51) Int. Cl.: H05K 7/14

(54) **MODULTRÄGER IM BEREICH DES SEKUNDÄREN EXPLOSIONSSCHUTZES**
MODULE SUPPORT IN THE AREA OF SECONDARY EXPLOSION PROTECTION
PORTE-MODULE DANS LA ZONE DE LA PROTECTION SECONDAIRE CONTRE LES EXPLOSIONS

(30) Priorität: 22.10.2020 DE 102020127795
(43) Veröffentlichungstag der Anmeldung: 27.04.2022
(73) Patentinhaber: Turck Holding GmbH, 58553 Halver (DE)
(72) Erfinder: Grabowski, Franz, 46509 Xanten (DE); Gabrysch, Adalbert, 46286 Dorsten (DE)
(74) Vertreter: DTS Patent- und Rechtsanwälte PartmbB

(56) Entgegenhaltungen:
- DE-U1- 202008 009 599
- "excom® - Remote I/O für Eigensichere Stromkreise HANDBUCH", 30 April 2019 (2019-04-30), XP002805758, Retrieved from the Internet <URL:https://www.turck.de/attachment/D301265.pdf> [retrieved on 20220221]

## Beschreibung

Die vorliegende Erfindung betrifft einen Modulträger mit mindestens einem Modul, insbesondere einem Netzteil, zum Einsatz im Ex-Bereich. Insbesondere betrifft die Erfindung einen Modulträger mit mindestens einem Modul, das beim Einsatz in explosionsgefährdeten Bereichen einen erhöhten Grad an Sicherheit aufweist, insbesondere in einem gas- oder staubexplosionsgefährdeten Bereich.

Im Rahmen des sekundären Explosionsschutzes, etwa in gas- oder staubexplosionsgefährdeten Bereichen, wird das Ziel verfolgt, wirksame Zündquellen zu vermeiden. Als Zündquellen werden vor allem auch Lichtbögen, und Funken berücksichtigt.

Ein Ansatz sieht hierbei vor, dass die betroffenen Leitungen und Kontakte mechanisch unlösbar fixiert werden. Ein anderer Ansatz sieht vor, dass vor dem Unterbrechen oder Schließen der Kontakte die Leitungen stromlos geschaltet sind, sodass es zu keiner Funken- oder Lichtbogenbildung kommen kann.

Einen wertvollen Beitrag zum Stand der Technik stellt beispielsweise das excom-System der Firma Turck dar. Hier wird das Netzteil stromlos geschaltet und erst nach dem Stecken wird durch Eindrehen und Verriegeln eines Gewindebolzens mittels eines induktiven Schalters das Gerät stromführend geschaltet.

Es ist Aufgabe der Erfindung, ein einfach zu bedienendes und zuverlässiges Netzteil zum Einsatz im Ex-Bereich zu schaffen.

Diese Aufgabe wird erfindungsgemäß gelöst durch die Merkmale des Anspruchs 1. Vorteilhafte Ausgestaltungen sind in den Unteransprüchen angegeben.

Danach wird die Aufgabe gelöst durch einen Modulträger für die Verwendung in einem explosionsgefährdeten Bereich, umfassend ein Gehäuse zur Aufnahme zumindest eines Moduls mit einem Taster, wobei das zumindest eine Modul über den Taster stromführend schaltbar ist. Dabei umfasst der Modulträger weiter eine Verriegelungskappe, wobei die Verriegelungskappe eine Vorrichtung zum Betätigen des Tasters aufweist. Dabei ist der Taster im unbetätigten Zustand nicht stromführend geschaltet und der Taster ist durch Verriegelung der Verriegelungskappe durch die Betätigungsvorrichtung betätigbar.

Dadurch kann vorteilhafterweise sichergestellt werden, dass das Modul nicht stromführend geschaltet ist, bevor es entnommen wird. Das Modul kann dadurch auch in explosionsgefährdeten Bereichen beispielsweise aus einem Schaltschrank ausgebaut werden, ohne dass hierzu größere Bereiche einer Anlage stromlos geschaltet werden müssen.

Der Modulträger ist demnach mit einer elektromechanischen Vorrichtung versehen, die verhindert, dass das Modul, insbesondere ein Netzteil, unter Spannung gezogen oder gesteckt werden kann. Die Verriegelungskappe ist dazu mit einer Vorrichtung zum Betätigen eines elektromechanischen Tasters versehen.

Der Modulträger der Erfindung kann ferner vorteilhafterweise kostengünstiger hergestellt werden als bei bisherigen Lösung, etwa mit einer Verriegelungsschraube und einem induktiven Schalter.

Der Modulträger kann ferner eine besonders vorteilhafte Bedienerfreundlichkeit aufweisen sowie eine deutlich und einfach erfassbare Haptik, welche die Bedienung weiter erleichtert. Ferner kann eine besonders schnelle Bedienbarkeit mit kurzen Ent- und Verriegelungszeiten gewährleistet werden.

Die Erfindung kombiniert insbesondere durch einen elektromechanischen Ansatz eine mechanische Fixierung und ein elektrisches Verbinden beziehungsweise Trennen des stromführenden Leiters.

Dies ermöglicht etwa den Austausch des Moduls in einer Ex-Zone 2 im laufenden Betrieb.

Bei einer Ausbildung ist das Modul ein Netzteilmodul. Dadurch wird vorteilhafterweise das Betreiben eines besonders relevanten Moduls erleichtert, welches im explosionsgefährdeten Bereich besondere Sicherheitsmaßnahmen erfordert.

Ferner kann vorgesehen sein, dass Versorgungsanschlüsse des Moduls, insbesondere des Netzteils, in der Zündschutzart "Erhöhte Sicherheit, Ex ec" ausgeführt sind.

Ferner kann beispielsweise eine HotPlug-Funktion in einer Ex-Zone 2 ohne Unterbrechung der Stromversorgung realisiert werden.

Dabei kann der Taster insbesondere als elektromechanischer Tastschalter ausgebildet sein. Er kann ferner als Betätigungsschalter ausgebildet sein.

Der Taster ist insbesondere mit einer "Normally Open" (NO)-Logik ausgebildet, das heißt, ein Stromkreis wird beim Betätigen des Tasters geschlossen und ist geöffnet, solange der Taster nicht betätigt wird. Der Taster mit der Schaltlogik "Normal open" ist also im unbetätigten Zustand nicht stromführend.

Bei dem Modulträger führt ein Betätigen des Tasters durch die Betätigungsvorrichtung insbesondere dazu, dass das Modul stromführend geschaltet wird, insbesondere indem durch den Taster ein Stromkreis geschlossen wird.

Insbesondere ist der Taster so ausgebildet, dass er einen eigensicheren Freigabekreis schaltet, der insbesondere über zumindest ein Relais das Modul, insbesondere ein Netzteilmodul oder ein PSM24-Modul, stromführend oder stromlos schaltet.

Bei einer Ausbildung weist das Gehäuse ein Käfigelement auf. Das Käfigelement ist insbesondere dazu ausgebildet, das Modul aufzunehmen und zumindest teilweise an seinem Rand zu umgeben. Beispielsweise kann das Käfigelement das Modul soweit umgeben, dass bei angebrachter Verriegelungskappe lediglich der Anschluss des Moduls zum Einbau an einem elektronischen Steckplatz zugänglich ist, etwa um das Modul an einem Steckplatz einzustecken.

Die Verriegelungskappe kann als Frontschild ausgebildet sein. Sie ist insbesondere dazu ausgebildet, das Modul im eingebauten Zustand in dem Modulträger für einen äußeren Nutzer zu verdecken. Die Verriegelungskappe muss somit entfernt werden, um das Modul entfernen zu können, etwa durch Herausziehen aus einem Steckplatz.

Bei einer Ausbildung weist die Verriegelungskappe zumindest einen Schnapphaken auf. Insbesondere sind zwei oder mehrere Schnapphaken vorgesehen. Es kann vorgesehen sein, dass die Schnapphaken mit einem Gehäuse des Modulträgers, etwa einem Käfigelement, eingreifen und so die Verriegelungskappe arretieren. Die Verriegelungskappe ist in diesem Fall fest mit dem Gehäuse oder Käfigelement verbunden, bis zumindest einer der Schnapphaken gelöst wird.

Die Verriegelungskappe kann ferner so ausgebildet und mit einem Schnapphaken versehen sein, dass sie nach dem Einrasten die Verriegelungskappe an dem darunterliegenden Modul arretiert ist und der Betätigungstaster im eigensicheren Kreis betätigt wird.

Bei einer Ausbildung liegt der Taster bei Verriegelung der Verriegelungskappe hinter der Verriegelungskappe hinter einer Modulkappe, die durch die Verriegelungskappe blockiert wird. Dadurch wird der Taster vorteilhafterweise gegen unbeabsichtigtes Betätigen beziehungsweise Öffnen geschützt.

Die Modulkappe ist insbesondere so ausgebildet, dass sie Frontseite des Moduls überdeckt beziehungsweise einen zum Nutzer hinweisenden Bereich an der Frontseite des Moduls zumindest teilweise aufnimmt. Die Modulkappe ist insbesondere so ausgebildet, dass der Nutzer das Modul nicht aus dem Modulträger herausnehmen kann, wenn er nicht die Modulkappe entfernt.

Die Modulkappe kann zwischen dem Modul und der Verriegelungskappe angeordnet sein.

Die an der Verriegelungskappe vorgesehene Vorrichtung zum Betätigen des Tasters ist daher insbesondere so ausgebildet, dass sie im arretierten Zustand durch die Modulkappe hindurch, etwa durch eine Ausnehmung oder Öffnung hindurch, den Taster betätigen kann.

Insbesondere kann die Modulkappe so ausgebildet sein, dass sie mit dem zumindest einen Käfigelement eingreift. Die Modulkappe und das Käfigelement könnten dabei lösbar miteinander verbunden werden, etwa durch eine Schnappverbindung oder eine Verriegelung.

Der Taster ist beispielsweise auf dem PSM24-Netzteilmodul hinter der Verriegelungskappe beziehungsweise hinter der Modulkappe angeordnet und somit gegen unbeabsichtigtes Betätigen geschützt.

Die Verriegelungskappe überdeckt das Modul im verriegelten Zustand so, dass unter der Verriegelungskappe das Modul nicht lösbar ist. Die Verriegelungskappe ist insbesondere so ausgebildet, dass das Modul, etwa ein Netzteil-Modul, so überdeckt wird, dass das unter der Verriegelungskappe angeordnete Modul nicht gelöst werden kann.

Beispielsweise ist die Verriegelungskappe so angeordnet, dass sie ein Herausziehen oder eine andere Bewegung des Moduls blockiert und im Wesentlichen unmöglich macht.

Dabei ist der Modulträger so ausgebildet, dass ein zeitgleiches Entfernen des Moduls und der Verriegelungskappe aus dem Modulträger konstruktiv ausgeschlossen ist. Insbesondere muss stets zunächst die Verriegelungskappe aus dem arretierten Zustand gelöst werden, wobei die Betätigung des Tasters beendet wird; erst dann ist es möglich, auch das Modul zu entfernen. Dadurch wird vorteilhafterweise sichergestellt, dass das Modul stets in einem nicht stromführenden Zustand entfernt wird.

Insbesondere ist dabei ein zeitgleiches Entfernen des Moduls, insbesondere des Netzteilmoduls beziehungsweise des PSM24-Netzteilmoduls, zusammen mit der Verriegelungskappe aus dem Modulträger konstruktiv ausgeschlossen.

Bei einer Ausbildung schaltet der Taster einen eigensicheren Freigabekreis, der über zumindest ein Relais das Modul stromführend oder stromlos schaltet. Dadurch wird vorteilhafterweise eine besonders sichere Umschaltung zwischen stromführendem und nicht stromführendem Zustand des Moduls erreicht.

Bei einer Ausbildung ist die Verriegelungskappe durchsichtig ausgestaltet. Insbesondere ist eine darunterliegende Beschriftung und/oder Statusanzeige durch die Verriegelungskappe von außen sichtbar. Zum Beispiel können Lichtsignale genutzt werden, um Signale des Moduls auszugeben und etwa Informationen über den Betriebszustand erfassbar zu machen.

Weitere Einzelheiten und Vorteile der Erfindung sollen nun anhand eines in den Zeichnungen dargestellten Ausführungsbeispiels näher erläutert werden.

Es zeigen:
- Fig. 1: eine schematische Ansicht des Ausführungsbeispiels des Modulträgers mit einem Modul im arretierten Zustand;
- Fig. 2: eine Verriegelungskappe in einem gelösten Zustand; und
- Fig. 3: eine Detailansicht des Modulträgers mit arretiertem Verriegelungselement.

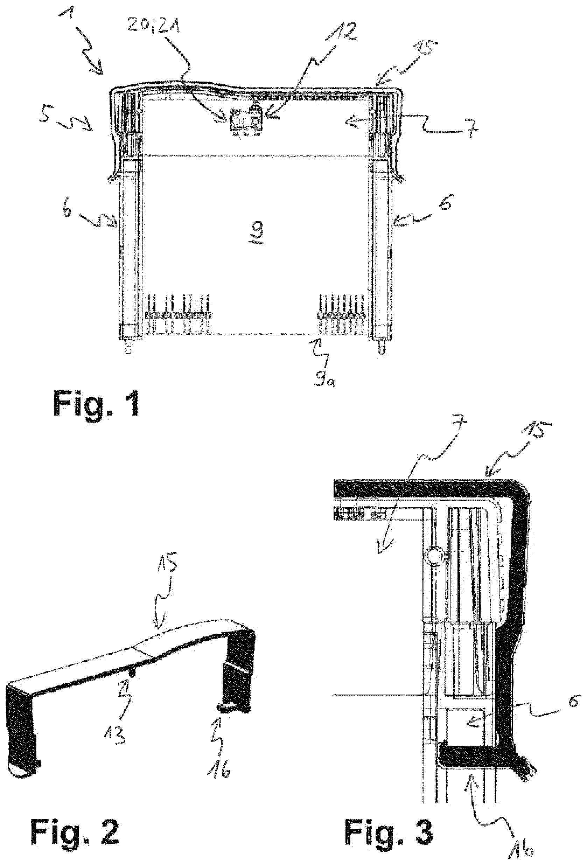

Mit Bezug zu den Fig. 1 bis 3 wird ein Ausführungsbeispiel des Modulträgers mit einem Modul erläutert.

Der Modulträger 1 umfasst ein Gehäuse 5. In dem Gehäuse 5 ist im gezeigten Fall das Modul 9 aufgenommen.

Das Modul 9 ist hier ein Netzteilmodul 9, insbesondere ein PSM24-Modul.

Das Modul 9 wird in den Modulträger 1 eingebaut, indem es beispielsweise mit einer Steckseite 9a in einen Steckplatz eingeschoben wird. Hierdurch werden elektrische Kontakte des Moduls 9 mit elektrischen Kontakten des Steckplatzes verbunden.

Das Gehäuse 5 umfasst bei dem Ausführungsbeispiel zwei seitliche Käfigelemente 6, die entlang den im Wesentlichen senkrecht zur Steckseite 9a des Moduls 9 angeordneten Seiten des Moduls 9 angeordnet sind und zwischen die das Modul 9 eingeschoben werden kann.

Das Gehäuse 9 umfasst ferner eine Modulkappe 7, die im gezeigten Fall die der Steckseite 9a abgewandte Seite des Moduls 9 aufnimmt.

Bei dem Ausführungsbeispiel sind die seitlichen Käfigelemente 6 und die Modulkappe 7 mittels Rasten verbunden, sodass die Modulkappe 7 gegen versehentliches Lösen von den seitlichen Käfigelementen 6 gesichert ist. Insbesondere wird dadurch sichergestellt, dass das Modul 9 nicht ohne vorheriges Entfernen der Modulkappe 7 entnommen werden kann.

Die seitlichen Käfigelemente 6 sind bei dem Ausführungsbeispiel dazu eingerichtet, fest mit einem Substrat seitlich eines Steckplatzes für das Modul 9 verbunden zu werden. Sie bilden dadurch Führungen, welche das Einschieben des Moduls 9 in den Steckplatz erleichtern.

Der Modulträger 1 umfasst ferner eine Verriegelungskappe 15, die nach der Kontur einer Modulkappe 7 ausgebildet ist.

Die Verriegelungskappe 15 hat eine bügelförmige Gestalt und wird über die Modulkappe 7 montiert.

Dabei weist die Verriegelungskappe 15 an zwei gegenüberliegenden Seiten jeweils Schnapphaken 16 auf, die an den seitlichen Käfigelementen 6 einrasten können, was ein versehentliches Lösen der Verriegelungskappe 15 verhindert. Die Verriegelungskappe 15 ist in diesem Zustand an der der Steckseite abgewandten Seite, das heißt an der Stirnseite des Moduls 9 arretiert. Sie kann insbesondere erst wieder gelöst werden, wenn zuvor die Schnapphaken 16 gelöst werden.

Die Verrieglungskappe 15 verdeckt ferner die Stirnseite des Moduls 9 sowie der Modulkappe 7.

Die Verriegelungskappe 15 überdeckt das Modul 9 im verriegelten Zustand derart, dass das Modul 9 unter der Verriegelungskappe 15 nicht lösbar ist. Das heißt umgekehrt, das Modul 9 ist nur dann lösbar und insbesondere aus einem Steckplatz entnehmbar, wenn zuvor die Verriegelungskappe 15 entfernt wird.

Dabei ist es zudem konstruktiv ausgeschlossen, das Modul 9 und die Verriegelungskappe 15 gleichzeitig aus dem Modulträger 1 zu entnehmen. Insbesondere kann die Verriegelungskappe nicht in ihrem verriegelten oder arretierten Zustand zusammen mit dem Modul 9 entnommen werden. Die Verriegelung der Verriegelungskappe 15 muss daher zunächst gelöst werden, um das Modul 9 aus dem Modulträger 1 entnehmen zu können.

Die Verriegelungskappe 15 weist ferner eine Betätigungsvorrichtung 13 auf. Diese Betätigungsvorrichtung 13 liegt bei Verriegelung der Verriegelungskappe 15 hinter der Verriegelungskappe 15.

Sie ist bei dem Beispiel als von der Verriegelungskappe 15 hervorstehender Stift oder länglicher Vorsprung ausgebildet, der sich zu dem Modul 9 hin erstreckt.

Insbesondere sind die Verriegelungskappe 15, die Schnapphaken 16 und die Betätigungsvorrichtung 13 einstückig ausgebildet, etwa in einem Kunststoffteil.

Wenn die Verriegelungskappe an dem Modulträger 1 mit dem Modul 9 arretiert ist, dann wird die Betätigungsvorrichtung 13 in Richtung des Moduls 9 gedrückt und betätigt dabei einen Taster 12, der von dem Modul 9 umfasst ist.

Insbesondere weist die Modulkappe 7 eine Ausnehmung auf, durch die hindurch die Betätigungsvorrichtung 13 zu dem Taster 12 des Moduls 9 reichen und diesen betätigen kann.

Umgekehrt wird der Taster 12 nicht mehr betätigt, wenn die Verriegelungskappe 15 entfernt wird.

Der Taster 12 ist so ausgebildet, dass bei seiner Betätigung, das heißt, wenn Druck auf den Taster 12 ausgeübt wird, ein Stromkreis geschlossen wird. Der Taster 12 schaltet bei dem Ausführungsbeispiel einen eigensicheren Freigabekreis 20 schaltet, der über ein Relais 21 das Modul 9 stromführend beziehungsweise stromlos schaltet.

Das Modul 9 ist dazu eingerichtet, dass es nur dann stromführend ist, solange der Taster 12 betätigt wird.

Umgekehrt ist der Stromkreis geöffnet, wenn der Taster 12 nicht betätigt wird, insbesondere wenn der verriegelte Zustand gelöst und die Verriegelungskappe 15 entfernt wird. Da der Taster 12 dann nicht mehr betätigt wird, ist auch das Modul 9 in einem nicht stromführenden Zustand.

Da die Verriegelungskappe 15 gelöst werden muss, um das Modul 9 entnehmen zu können, wird daher sichergestellt, dass das Modul 9 zunächst in einen nicht stromführenden Zustand gebracht wird, ehe dann das Modul 9 entnommen werden kann.

Bei weiteren Ausführungsbeispielen sind andere Ausbildungen der Betätigungsvorrichtung 13 vorgesehen. Ferner können verschiedene Arten von Tastern 12 vorgesehen sein. Beispielsweise kann ein magnetisch und/oder induktiv betätigbarer Taster 12 oder ein alternativer Schalter vorgesehen sein; der Taster 12 kann ferner auf andere Weise als ein klassischer Tastschalter ausgebildet sein. Entsprechend dem Typ des Tasters 12 ist die Betätigungsvorrichtung 13 so ausgebildet, dass sie den Taster 12 betätigt, wenn die Verriegelungskappe 15 an dem Modulträger 1 arretiert ist.

Insbesondere ist der Taster 12 oder ein alternativer Schalter so ausgebildet, dass das Modul 9 nur während des Betätigens durch das Betätigungselement 13 der Verriegelungskappe 15 stromführend geschaltet wird.

Im eingebauten Zustand des Modulträgers 1 verdeckt die arretierte Verriegelungskappe 15 die Sicht auf die Frontseite der Modulkappe 7 und des Moduls 9 für einen Nutzer. Bei dem Ausführungsbeispiel ist die Verriegelungskappe 15 durchsichtig ausgebildet, sodass etwa Beschriftungen der Modulkappe 7 und/oder des Moduls 9 sichtbar sind sowie Lichtsignale und Statusanzeigen erfasst werden können, etwa das Licht einer LED.

Mit dem erfindungsgemäßen Modulträger 1 wird demnach erreicht, dass das Modul 9 in einem eingebauten Zustand durch eine arretierte Verriegelungskappe 15 fixiert wird. Dabei betätigt eine Betätigungsvorrichtung 13 einen Taster 12 des Moduls 9, solange die Verriegelungskappe 15 arretiert ist. Durch diese Betätigung wird das Modul 9 stromführend geschaltet. Zum Ausbau des Moduls 9 muss zunächst die Verriegelungskappe 15 aus der Arretierung gelöst werden. Dies führt zum Deaktivieren des Tasters 12 und damit zum Schalten des Moduls 9 in einen stromlosen Zustand. Erst anschließend kann das Modul 9 entnommen werden.

### Bezugszeichenliste

- 1: Modulträger
- 5: Gehäuse
- 6: Seitliches Käfigelement
- 7: Modulkappe
- 9: Modul; Netzteilmodul
- 9a: Steckseite
- 12: Taster
- 13: Betätigungsvorrichtung für den Taster 12
- 15: Verriegelungskappe
- 16: Schnapphaken
- 20: Freigabekreis
- 21: Relais

## Patentansprüche

1. Modulträger (1) für die Verwendung in einem explosionsgefährdeten, insbesondere in einem gas- oder staubexplosionsgefährdeten Bereich, umfassend ein Gehäuse (5) zur Aufnahme zumindest eines Moduls (9), **dadurch gekennzeichnet, dass**
das Modul (9) einen Taster (12) aufweist,
wobei das zumindest eine Modul (9) über den Taster (12) stromführend schaltbar ist,
wobei der Modulträger (1) weiter eine Verriegelungskappe (15) umfasst, wobei die Verriegelungskappe (15) eine Vorrichtung (13) zum Betätigen des Tasters (12) aufweist und
wobei der Taster (12) im unbetätigten Zustand nicht stromführend geschaltet ist und der Taster (12) durch Verriegelung der Verriegelungskappe (15) durch die Betätigungsvorrichtung (13) betätigbar ist,
wobei die Verriegelungskappe (15) das Modul (9) im verriegelten Zustand so überdeckt, dass unter der Verriegelungskappe (15) das Modul (9) nicht lösbar ist; und
wobei ein zeitgleiches Entfernen des Moduls (9) und der Verriegelungskappe (15) aus dem Modulträger (1) konstruktiv ausgeschlossen ist.

2. Modulträger (1) nach Anspruch 1, wobei das Modul (9) ein Netzteilmodul (9) ist.

3. Modulträger (1) nach einem der vorhergehenden Ansprüche, wobei das Gehäuse (5) ein Käfigelement (6) aufweist.

4. Modulträger (1) nach einem der vorhergehenden Ansprüche, wobei die Verriegelungskappe (15) zumindest einen Schnapphaken (16) aufweist.

5. Modulträger (1) nach einem der vorhergehenden Ansprüche, wobei der Taster (12) bei Verriegelung der Verriegelungskappe (15) hinter einer Modulkappe (7) liegt, die durch die Verriegelungskappe (15) blockiert wird.

6. Modulträger (1) nach einem der vorhergehenden Ansprüche, wobei der Taster (12) einen eigensicheren Freigabekreis (20) schaltet, der über ein Relais (21) das Modul (9) stromführend oder stromlos schaltet.

7. Modulträger (1) nach einem der vorhergehenden Ansprüche, wobei die Verriegelungskappe (15) durchsichtig ausgestaltet ist.

## Claims

1. Module support (1) for use in a potentially explosive atmosphere, in particular in a potentially explosive atmosphere in the form of gas or dust, comprising a housing (5) for receiving at least one module (9), **characterized in that**
the module (9) has a pushbutton (12),
wherein the at least one module (9) is switchable to the live state via the pushbutton (12),
wherein the module support (1) further comprises a locking cap (15),
wherein the locking cap (15) has a device (13) for actuating the pushbutton (12) and
wherein, in the unactuated state, the pushbutton (12) is switched to the non-live state and, by locking the locking cap (15), the pushbutton (12) can be actuated by the actuating device (13),
wherein, in the locked state, the locking cap (15) covers the module (9) such that the module (9) is not releasable under the locking cap (15); and
wherein simultaneous removal of the module (9) and the locking cap (15) from the module support (1) is prevented by the structural design.

2. Module support (1) according to Claim 1, wherein the module (9) is a power supply unit module (9).

3. Module support (1) according to one of the preceding claims, wherein the housing (5) is a cage element (6) .

4. Module support (1) according to one of the preceding claims, wherein the locking cap (15) has at least one snap hook (16).

5. Module support (1) according to one of the preceding claims, wherein, when the locking cap (15) is locked, the pushbutton (12) lies behind a module cap (7), which is blocked by the locking cap (15).

6. Module support (1) according to one of the preceding claims, wherein the pushbutton (12) switches an intrinsically safe release circuit (20), which switches the module (9) to the live state or the non-live state via a relay (21).

7. Module support (1) according to one of the preceding claims, wherein the locking cap (15) is designed as translucent.

## Revendications

1. Support de module (1) pour l'utilisation dans une zone à risque d'explosion, notamment dans une zone à risque d'explosion de gaz ou de poussière, comprenant un boîtier (5) pour recevoir au moins un module (9), **caractérisé en ce que**
le module (9) présente un bouton-poussoir (12),
l'au moins un module (9) pouvant être commuté sous tension par l'intermédiaire du bouton-poussoir (12),
le support de module (1) comprenant en outre un capuchon de verrouillage (15),
le capuchon de verrouillage (15) présentant un dispositif (13) pour actionner le bouton-poussoir (12) et
le bouton-poussoir (12) n'étant pas commuté sous tension à l'état non actionné et le bouton-poussoir (12) pouvant être actionné par verrouillage du capuchon de verrouillage (15) par le dispositif d'actionnement (13), le capuchon de verrouillage (15) recouvrant le module (9) à l'état verrouillé de telle sorte que le module (9) ne peut pas être détaché sous le capuchon de verrouillage (15) ; et
un retrait simultané du module (9) et du capuchon de verrouillage (15) du support de module (1) étant exclu par construction.

2. Support de module (1) selon la revendication 1, le module (9) étant un module d'alimentation (9).

3. Support de module (1) selon l'une quelconque des revendications précédentes, le boîtier (5) présentant un élément de cage (6).

4. Support de module (1) selon l'une quelconque des revendications précédentes, le capuchon de verrouillage (15) présentant au moins un crochet d'encliquetage (16).

5. Support de module (1) selon l'une quelconque des revendications précédentes, lorsque le capuchon de verrouillage (15) est verrouillé, le bouton-poussoir (12) se trouvant derrière un capuchon de module (7) qui est bloqué par le capuchon de verrouillage (15).

6. Support de module (1) selon l'une quelconque des revendications précédentes, le bouton-poussoir (12) commutant un circuit de validation à sécurité intrinsèque (20) qui, par l'intermédiaire d'un relais (21), commute le module (9) sous tension ou hors tension.

7. Support de module (1) selon l'une quelconque des revendications précédentes, le capuchon de verrouillage (15) étant conçu sous forme transparente.
